# EUROPEAN PATENT APPLICATION

(11) **EP 4 709 100 A2**
(43) Date of publication of application: **11.03.2026**
(21) Application number: 26150497.1
(22) Date of filing: 07.01.2026
(51) Int. Cl.: H10F 71/00, H10F 77/14

(54) **SOLAR CELL**

(30) Priority: 07.04.2025 CN 202510428276
(71) Applicant: Shangrao Jinko Solar No.3 Intelligent Manufacturing Co. Ltd, Shangrao, Jiangxi Province 334000 (CN); Jinko Solar (Haining) Co., Ltd., Haining City, Zhejiang 314415 (CN)
(72) Inventor: WANG, Ruhao, Shangrao.JIANGXI PROVINCE, 334000 (CN); CUI, Wei, Shangrao.JIANGXI PROVINCE, 334000 (CN); JIN, Jingsheng, Shangrao.JIANGXI PROVINCE, 334000 (CN)
(74) Representative: Herrero & Asociados, S.L.

(57) **Abstract**

A solar cell and a method for preparing the solar cell are provided. The solar cell is formed by cutting a whole cell and includes: a cell substrate (10) and a plurality of textures (11) arranged in the cell substrate (10), the plurality of textures (11) being spaced apart from each other along a first direction. In the first direction, a density of plurality of the textures is 1 texture per 10 µm to 30 textures per 10 µm, and the first direction is perpendicular to a thickness direction of the cell substrate (10).

## Description

### TECHNICAL FIELD

The present invention relates to the technical field of semiconductors, and in particular to a solar cell and a method for preparing the solar cell.

### BACKGROUND

In current half-cell preparation processes, a high-power thermal cleaving laser is used for heating the silicon wafer, followed by spraying cooling water at the same location to generate a temperature-gradient field, inducing thermal stress. When the resulting tensile stress reaches the fracture limit of silicon material, the silicon wafer cleaves cleanly, accomplishing the cutting. A temperature difference of 150 °C to 250 °C between the top and bottom surfaces is required. Since the (100), (110) and (111) crystal planes are the dominant cleavage planes in silicon and their fracture toughness is comparable, the thermal stress is released unevenly along these three crystal orientations once it exceeds the respective fracture strengths. This leads to a high density of striated grooves on the cut cross-section, exposing numerous dangling bonds along the three crystal orientations, drastically increasing local recombination density and adversely affecting subsequent formation of the passivation film.

### SUMMARY

According to various embodiment, a solar cell and a preparation method thereof are provided.

The solar cell includes a cell substrate and a plurality of textures arranged in the cell substrate. The cell substrate includes a front surface, a back surface, and a side surface connecting the front surface and the back surface. The plurality of textures are formed on the side surface and spaced apart from each other in a first direction. In the first direction, a density of plurality of the textures is in a range from 1 texture per 10 µm to 30 textures per 10 µm, and the first direction is perpendicular to a thickness direction of the cell substrate.

In one embodiment, a depth of the texture in a second direction is in a range from 0.1 µm to 3 µm, the second direction is perpendicular to the thickness direction of the cell substrate, and the second direction intersects the first direction.

In one embodiment, a width of the texture in the first direction is in a range from 0 µm to 1 µm.

In one embodiment, the side surface is formed by cutting.

In one embodiment, the solar cell further includes a passivation film formed on the side surface.

In one embodiment, the passivation film includes a first passivation sub-film covering the plurality of textures and a second passivation sub-film formed on the first passivation sub-film.

In one embodiment, a thickness of the second passivation sub-film is greater than a thickness of the first passivation sub-film.

In one embodiment, the thickness of the first passivation sub-film in the second direction is in a range from 10 nm to 20 nm, and the thickness of the second passivation sub-film in the second direction is in a range from 40 nm to 50 nm.

In one embodiment, the passivation film is made of aluminum oxide, silicon oxide, or silicon nitride.

In one embodiment, the spacing between adjacent two textures ranges from 0.3 µm to 9 µm.

In one embodiment, sectional shapes of the plurality of textures include at least one of linear, wavy, or zigzag.

In one embodiment, the cell substrate comprises a silicon substrate and further comprises an emitter, a passivation layer, and a first antireflection film that are stacked on one side of the silicon substrate, and also comprises a tunneling layer, a doped conductive layer, and a second antireflection film that are stacked on another side of the silicon substrate.

In one embodiment, a doping type of the emitter is different from a doping type of doped conductive layer.

In one embodiment, the cell substrate further comprises a plurality of first metal electrodes spaced apart from each other on a surface of the first antireflection film away from the silicon substrate, and a plurality of second metal electrodes spaced apart from each other on a surface of the second antireflection film away from the silicon substrate.

In one embodiment, the silicon substrate is doped with at least one of phosphorus (P), bismuth (Bi), antimony (Sb), or arsenic (As).

In one embodiment, a depth of the texture located at both ends of the cell substrate in the first direction is greater than a depth of the texture located in a central part of the cell substrate.

In one embodiment, the tunneling layer is made of at least one of silicon oxide, silicon nitride, silicon oxynitride, silicon carbide, or magnesium fluoride.

In one embodiment, the passivation layer is made of one or more selected from the group consisting of silicon oxide, silicon nitride, silicon oxynitride, silicon oxycarbonitride, titanium oxide, hafnium oxide, and aluminum oxide.

In one embodiment, the passivation layer is a single-layer aluminum oxide film, a single-layer silicon oxide film, a single-layer silicon nitride film, or a single-layer silicon oxynitride film.

In one embodiment, the passivation layer is formed by stacking at least two layers of aluminum oxide film, silicon oxide film, silicon nitride film, or silicon oxynitride film.

According to another aspect of the present invention, a method for preparing any of the above-described solar cell includes: providing a whole cell; laser cutting the whole cell along a thickness direction of the whole cell to obtain a plurality of solar cells. The solar cell includes a cell substrate and a plurality of textures arranged in the cell substrate. The cell substrate includes a front surface, a back surface, and a side surface connecting the front surface and the back surface. The plurality of textures are formed on the side surface and spaced apart from each other in a first direction. In the first direction, a density of plurality of the textures is in a range from 1 texture per 10 µm to 30 textures per 10 µm, and the first direction is perpendicular to the thickness direction of the cell substrate.

According to the technical solution of the present invention, the solar cell is formed by cutting a whole cell, and the solar cell includes a cell substrate and a plurality of textures arranged in the cell substrate. The plurality of textures are spaced apart from each other in a first direction, and the density of plurality of the textures in the first direction is in a range from 1 texture per 10 µm to 30 textures per 10 µm. Compared with the issues in existing technology where high recombination and poor carrier transport in half-cells lead to lower module power, the density of plurality of the textures in the present invention is in a range from 1 texture per 10 µm to 30 textures per 10 µm, which can significantly reduce the number of dangling bonds. The reduction in the number of dangling bonds decreases the non-radiative recombination rate of carriers at the surface, thereby improving the conversion efficiency of the cell. Additionally, the relatively low density of textures can make the section smoother, helping to reduce obstacles in the carrier transport path, thus improving carrier transport efficiency and thereby ensuring relatively high module power.

### BRIEF DESCRIPTION OF THE DRAWINGS

The drawings, which form a part of the present invention, are provided to offer a further understanding of the present invention. The illustrative embodiments and their descriptions in the present invention are intended to explain the application and do not constitute an undue limitation thereof. In the drawings:
FIG. 1 is a schematic top view of a solar cell according to an embodiment of the present invention.
FIG. 2 is a schematic top view of a specific solar cell according to an embodiment of the present invention.
FIG. 3 is a schematic cross-sectional structural view of a solar cell according to an embodiment of the present invention.

Reference signs:
10: cell substrate; 11: texture; 101: side surface; 12: passivation film; 13: silicon substrate; 14: emitter; 15: passivation layer; 16: first antireflection film; 17: tunneling layer; 18: doped conductive layer; 19: second antireflection film; 20: first metal electrode; 21: second metal electrode.

### DETAILED DESCRIPTION

It should be noted that the following detailed descriptions are exemplary and intended to provide further explanation of the present invention. Unless defined otherwise, all technical and scientific terms used herein have the same meaning as commonly understood by those skilled in the art of the present invention.

It should be noted that the terms used herein are merely for describing specific embodiments and are not intended to limit exemplary embodiments of the present invention. As used herein, unless the context clearly indicates otherwise, the singular forms are intended to include the plural forms. In addition, it should be understood that when the terms "comprise" and/or "include" are used in the present specification, they indicate the presence of stated features, steps, operations, devices, components, and/or combinations thereof.

It should be understood that when an element (such as a layer, film, region, or substrate) is described as being "on" another element, the element may be directly on the other element, or there may be an intermediate element. Moreover, in the specification and the claims, when an element is described as being "connected" to another element, the element may be "directly connected" to the other element or "connected" to the other element through a third element.

As introduced in the background, conventional half-cell thus suffers from excessive dangling bonds, high recombination, poor carrier transport, and degraded passivation-film quality in the striated grooves. In addition, conventional half-cell suffers from high recombination and poor carrier transport, which leads to low module power output. To address such issues, embodiments of the present invention provide a solar cell and a method for preparing the solar cell.

The technical solutions in the embodiments of the present invention will be described clearly and comprehensively below with reference to the accompanying drawings used in the embodiments of the present invention.

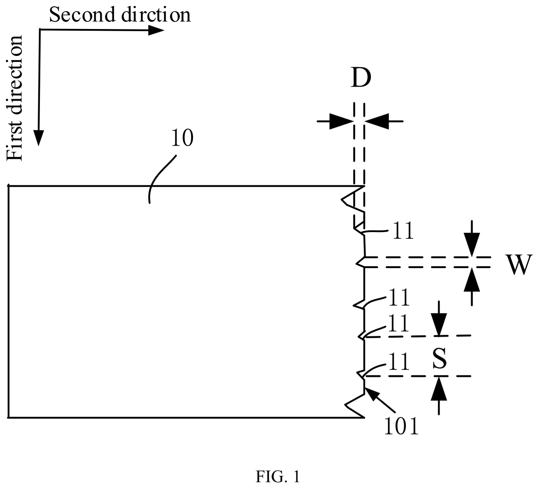

An embodiment of the present invention provides a solar cell, which is formed by cutting a whole cell. As shown in FIGS. 1, 2, and 3, the solar cell includes a cell substrate 10 and a plurality of textures 11 arranged in the cell substrate 10. The cell substrate 10 includes a front surface, a back surface, and a side surface 101 connecting the front surface and the back surface. The plurality of textures 11 are formed on the side surface 101 and are spaced apart from each other in a first direction. In the first direction, a density of plurality of the textures 11 is in a range from 1 texture per 10 µm to 30 textures per 10 µm, and the first direction is perpendicular to a thickness direction of the cell substrate 10.

The density of plurality of the textures 11 in a certain direction used herein refers to the number of textures per unit length.

According to the above embodiment, the solar cell is formed by cutting a whole cell, and the solar cell includes a cell substrate 10 and a plurality of textures 11 arranged in the cell substrate 10. The plurality of textures 11 are spaced apart from each other in a first direction, and the density of plurality of the textures 11 in the first direction is in a range from 1 texture per 10 µm to 30 textures per 10 µm. Compared with the issues in conventional technology where high recombination and poor carrier transport in half-cells lead to lower module power, the density of plurality of the textures 11 is in a range from 1 texture per 10 µm to 30 textures per 10 µm, which can significantly reduce the number of dangling bonds. The reduction in the number of dangling bonds decreases the non-radiative recombination rate of carriers at the surface, thereby improving the conversion efficiency of the cell. Additionally, the relatively low density of textures can make the section smoother, which is conducive to reducing obstacles in the carrier transport path, thus improving carrier transport efficiency and thereby ensuring relatively high module power.

Furthermore, on surfaces with high-density textures in the conventional art, the passivation film is deposited unevenly at the grooves, forming defects that adversely affect its densification and coverage, thereby reducing the passivation effect. In the aforementioned embodiment, by reducing the density of the textures 11, a smoother surface can be obtained, which facilitates the uniform growth and improved densification of the subsequent passivation film 12. This not only reduces defects in the passivation film 12 but also ensures consistent passivation effect across the entire cell surface, thereby increasing the open-circuit voltage and fill factor of the cell.

Specifically, the reason why a reduction in the density of the textures can decrease the number of dangling bonds is primarily related to the crystal structure of silicon material and the texture formation mechanism. During the cutting process of a solar cell, whether by mechanical cutting or laser cutting, microscopic textures are generated on the cell sectional surface. These textures may disrupt the crystal continuity of the silicon material, resulting in dangling bonds within the crystal structure, i.e., sites of unpaired valence electrons. Dangling bonds act as recombination sources for carriers, increasing the surface recombination rate and reducing cell efficiency. A decrease in the density of textures means that within a unit length, the number of textures is reduced, thereby consequently decreasing the number of dangling bonds caused by the textures.

Specifically, only textures with a depth in the second direction ranging from 0.1 µm to 3 µm can be defined as the textures. That is, when calculating the density of textures in the first direction, only those textures with a depth in the second direction ranging from 0.1 µm to 3 µm are considered.

In some embodiments, the solar cell can be any one of a Passivated Emitter Rear (PERC) Cell, a Passivated Emitter and Rear Totally Diffused (PERT) cell, a Tunnel Oxide Passivated Contact (TOPCon) cell, a Heterojunction Technology (HIT/HJT) cell, or a Back Contact (BC) cell.

In some embodiments, the solar cell can be a monocrystalline silicon photovoltaic cell, a polycrystalline silicon photovoltaic cell, an amorphous silicon photovoltaic cell, or a multi-compound photovoltaic cell. The multi-compound photovoltaic cell can specifically be a cadmium sulfide photovoltaic cell, a gallium arsenide photovoltaic cell, a copper indium selenide photovoltaic cell, or a perovskite photovoltaic cell.

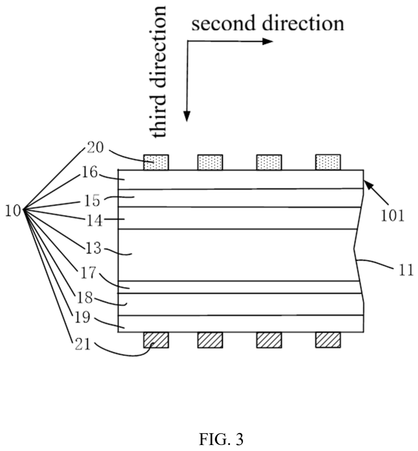

Taking a TOPCon cell as an example, as shown in FIG. 3, the cell substrate 10 of the solar cell includes a silicon substrate 13, and further includes an emitter 14, a passivation layer 15, and a first antireflection film 16 stacked sequentially on one side of the silicon substrate 13. The cell substrate 10 also includes a tunneling layer 17, a doped conductive layer 18, and a second antireflection film 19 stacked sequentially on the other side of the silicon substrate 13. The cell substrate 10 further includes a plurality of first metal electrodes 20 spaced apart from each other on the surface of the first antireflection film 16 away from the silicon substrate 13, and a plurality of second metal electrodes 21 spaced apart from each other on the surface of the second antireflection film 19 away from the silicon substrate 13. The doping types of the emitter 14 and the doped conductive layer 18 are different. The first metal electrode is electrically connected to the emitter, and the second metal electrode is electrically connected to the doped conductive layer. The silicon substrate 13 is configured for receiving incident light and generating photogenerated carriers. The first metal electrode 20 and the second metal electrode 21 are configured for collecting the photogenerated carriers. The passivation layer 15 can prevent oxidation or corrosion of the emitter surface to improve the stability and lifespan of the whole cell. The tunneling layer 17 can provide chemical passivation. Due to interface state defects on the substrate surface, the tunneling layer 17 can saturate the dangling bonds on the substrate surface, reduce the defect state density on the substrate surface, and decrease the carrier recombination rate by reducing recombination centers on the substrate surface, so that the interface state density on the substrate surface can be increased. The increase in interface state density promotes the recombination of photogenerated carriers, increasing the fill factor, short-circuit current, and open-circuit voltage of the photovoltaic cell, thereby improving the photoelectric conversion efficiency of the photovoltaic cell. The first antireflection film 16 and the second antireflection film 19 can reduce the reflectivity of sunlight on the surface of the photovoltaic cell, allowing more light to be absorbed and converted into electrical energy, thereby improving the light absorption efficiency of the photovoltaic cell. Additionally, the antireflection films can protect the internal structure of the cell, prevent the cell from environmental contamination, and improve the stability of the photovoltaic cell.

Specifically, the silicon substrate can be made of at least one of monocrystalline silicon, polycrystalline silicon, amorphous silicon, or microcrystalline silicon. The material of the passivation layer can include one or more selected from the group consisting of silicon oxide, silicon nitride, silicon oxynitride, silicon oxycarbonitride, titanium oxide, hafnium oxide, aluminum oxide and the like. The passivation layer can have a single-layer structure or a multilayer structure. For example, the single-layer structure can be a single-layer aluminum oxide film, a single-layer silicon oxide film, a single-layer silicon nitride film, or a single-layer silicon oxynitride film. The multilayer structure can be formed by stacking at least two layers of aluminum oxide film, silicon oxide film, silicon nitride film, or silicon oxynitride film. The substrate can be an N-type semiconductor substrate or a P-type semiconductor substrate. The N-type semiconductor substrate is doped with N-type dopants, which can be at least one of Group V elements such as phosphorus (P), bismuth (Bi), antimony (Sb), or arsenic (As). The P-type semiconductor substrate is doped with P-type dopants, which can be at least one of Group III elements such as boron (B), aluminum (Al), gallium (Ga), or indium (In). The material of the tunneling layer can include at least one of silicon oxide, silicon nitride, silicon oxynitride, silicon carbide, or magnesium fluoride.

Specifically, according to an embodiments, the silicon substrate is an N-type silicon substrate, the emitter is a P+ emitter, and the doped conductive layer is an n+poly layer (i.e., n-type doped polysilicon layer).

Specifically, when cutting the whole cell, the cutting line is required to be set at a location where no metal electrode is presented.

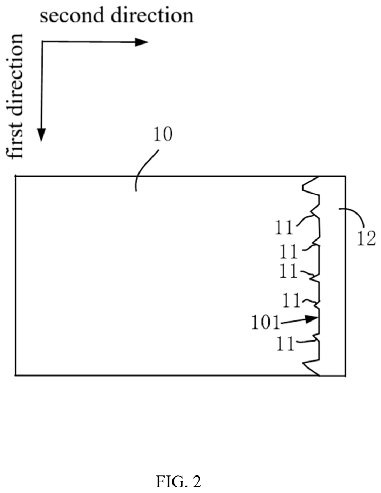

Specifically, as shown in FIGS. 1 and 2, the textures located at both ends of the cell substrate 10 in the first direction have irregular shapes. The depth of these textures in the second direction is greater than the depth of the texture 11 located in a central part of the cell substrate 10 in the first direction. Furthermore, these textures are discontinuous in the third direction, meaning they may have fragmented segments. Therefore, the aforementioned textures generally do not include these textures located at the two ends of the solar cell in the first direction. As shown in FIG. 3, the third direction is parallel to the thickness direction of the cell substrate 10.

In one embodiment, as shown in FIG. 1, the depth (D) of the texture 11 in the second direction is in a rage from 0.1 µm to 3 µm. The second direction is perpendicular to the thickness direction of the cell substrate, and the second direction intersects the first direction. In this embodiment, reducing the depth of the textures 11 means reducing the surface area at the cross-section, thereby decreasing the number of exposed dangling bonds. Dangling bonds are significant sites for carrier recombination; therefore, the reduction in depth helps further decrease the surface recombination rate, further enhancing carrier lifetime and efficiency.

According to some embodiments, as shown in FIG. 1, a width (W) of the texture 11 in the first direction is in a range from 0 µm to 1 µm. In this embodiment, since the width of the texture 11 in the first direction is reduced, the solar cell can be more uniformly covered by the passivation film 12 during the subsequent passivation process, thus further reducing discontinuity or defects of the passivation film 12 in relatively wide grooves. As such, the integrity of the passivation film 12 can be enhanced, the passivation effect can be improved, and the surface recombination rate can be further reduced.

According to some embodiments, as shown in FIGS. 1, 2, and 3, the side surface 101 is formed by cutting. The textures 11 extend from the side surface 101 into the cell substrate 10. As shown in FIG. 2, the solar cell further includes a passivation film 12 formed on the side surface 101 and covering the textures 11. In this embodiment, the passivation film 12 can effectively passivate the dangling bonds on the side surface 101 and in the textures 11, reducing surface recombination, further improving carrier lifetime and the open-circuit voltage of the cell, thereby further increasing module power. Additionally, the passivation film 12, especially covering the textures 11 and the side surface 101, can effectively block impurities from the environment from entering the interior of the solar cell and reduce surface defects, thereby improving the stability of the cell.

Specifically, the textures 11 can improve the flatness of the side surface 101, thereby benefiting the film formation quality and uniformity of the passivation film 12, improving the growth uniformity and denseness of the passivation film 12. As a result, the quality and density of the passivation film 12 can be significantly increased, and the coverage can be made more complete, reducing the passivation non-uniformity phenomenon in the grooves of the textures 11, achieving certain improvements in open-circuit voltage and fill factor, and thereby increasing module power.

According to other embodiments, the passivation film 12 includes a first passivation sub-film and a second passivation sub-film. The first passivation sub-film covers the textures 11. The second passivation sub-film is formed on the first passivation sub-film. The thickness of the second passivation sub-film in a second direction is greater than the thickness of the first passivation sub-film in the second direction. The second direction is perpendicular to the thickness direction of the cell substrate, and the second direction intersects with a first direction. In this embodiment, the first passivation sub-film on the textures 11 is relatively thin, ensuring that dangling bonds inside the textures are passivated while avoiding the formation of voids or delamination in the texture due to an overly thick passivation film, which may affect the uniformity and denseness of the passivation film 12. The thicker second passivation sub-film can better resist erosion from the external environment, improving the weather resistance and long-term stability of the solar cell.

In still other embodiments, the thickness of the first passivation sub-film in the second direction is in a range from 10 nm to 20 nm, and the thickness of the second passivation sub-film in the second direction is in a range from 40 nm to 50 nm. In these embodiments, setting the thicknesses of the first passivation sub-film and the second passivation sub-film in the second direction within the aforementioned ranges aims to minimize the impact of the passivation film on the electrical performance of the cell while reducing surface recombination. An overly thick passivation film can increase the resistance of the cell, while an overly thin passivation film may not effectively passivate surface defects.

In yet other embodiments, the passivation film 12 is made of aluminum oxide, silicon oxide, or silicon nitride. In these embodiments, selecting aluminum oxide, silicon oxide, or silicon nitride as the material of the passivation film 12 is because these materials have good passivation effects and stability, so that surface recombination can be further effectively reduced and the photoelectric conversion efficiency of the solar cell can be further improved. Furthermore, aluminum oxide and silicon nitride have a high refractive index, helping to further enhance light trapping capability.

According to other embodiments, as shown in FIG. 1, the spacing (S) between adjacent two textures is in a range from 0.3 µm to 9 µm. In these embodiments, controlling the spacing can effectively adjust the microstructure of the cell surface, ensuring the carrier transport path between the texture region and the passivation film 12 is optimized, helping to further improve the fill factor and open-circuit voltage of the cell.

In other embodiments, the sectional shape of the texture 11 includes at least one of linear, wavy, or zigzag. In these embodiments, designing the shape of the texture 11 as linear, wavy, or zigzag aims to optimize light scattering and absorption effects according to different lighting conditions and cell material characteristics. Wavy or zigzag textures can more effectively scatter incident light, increasing the path length of light within the cell, thereby improving light absorption rate.

Specifically, a comparison between the textures of half-cell cells in conventional technology and the textures 11 of the solar cell according to some embodiments is shown in Table 1.

**Table 1**

| Texture | Density in first direction | Depth in second direction | Width in first direction |
|---|---|---|---|
| Conventional technology | 100 per 10 µm to 200 per 10 µm | 1 µm to 20 µm | 0 µm to 3 µm |
| Embodiments | 1 per 10 µm to 30 per 10 µm | 0.1 µm to 3 µm | 0 µm to 1 µm |

Specifically, compared with half-cell solar cells in the conventional technology, the solar cell according to some embodiments can increase an open-circuit voltage by 0.5 mV, a fill factor by 0.3 to 0.4, a solar cell efficiency by 3% to 5%, and a photovoltaic module power by 0.5W to 1W.

The embodiments further provide a method for manufacturing a solar cell, the method including the following steps:
Step S201, a whole cell is provided.
Step S202, the whole cell is laser cut along the thickness direction of the whole cell to obtain a plurality of solar cells. The solar cell includes a cell substrate and a plurality of textures arranged in the cell substrate. The cell substrate includes a front surface, a back surface, and a side surface connecting the front surface and the back surface. The plurality of textures are are formed on the side surface and spaced apart from each other along a first direction. In the first direction, the density of plurality of the textures is in a range from 1 texture per 10 µm to 30 textures per 10 µm, the first direction is perpendicular to the thickness direction of the cell substrate.

According to the above embodiments, a whole cell is first provided, and the whole cell is then subjected to laser cutting along its thickness direction to obtain a plurality of solar cells. The solar cell includes a cell substrate and a plurality of textures arranged in the cell substrate, the plurality of textures being spaced apart from each other along a first direction. In the first direction, the density of plurality of the textures is in a range from 1 texture per 10 µm to 30 textures per 10 µm. Compared with the issues in conventional technology where high recombination and poor carrier transport in half-cells lead to lower module power, the texture density of 1 texture per 10 µm to 30 textures per 10 µm in the present invention can significantly reduce the number of dangling bonds. The reduction in the number of dangling bonds decreases the non-radiative recombination rate of carriers at the surface, thereby improving the conversion efficiency of the cell. Additionally, the relatively low texture density makes the side surface smoother, helping to reduce obstacles in the carrier transport path, thus improving carrier transport efficiency and consequently ensuring higher module power.

Specifically, taking the whole cell as a TOPCon cell as an example, providing the whole cell including: providing an N-type silicon substrate, forming a P+ emitter on an upper surface of the silicon substrate, forming a tunneling layer on a lower surface of the silicon substrate, forming a passivation layer on an upper surface of the P+ emitter, forming an n+ poly layer on a lower surface of the tunneling layer, forming a first antireflection film on an upper surface of the passivation layer, forming a second antireflection film on a lower surface of the n+poly layer, forming a plurality of first metal electrodes spaced from each other on an upper surface of the first antireflection film, and forming a plurality of second metal electrodes spaced from each other on a lower surface of the second antireflection film. The first metal electrodes are electrically connected to the P+ emitter, and the second metal electrodes are electrically connected to the n+ poly layer.

Specifically, the specific process for cutting the whole cell is as follows: first, laser grooving is performed at both ends of a first cutting line on the whole cell; then, preheating is applied to the location of the first cutting line; next, thermal cleavage laser scanning is performed on the location of the first cutting line; finally, cooling is applied to the location of a second cutting line to cause the cooled whole cell to split, obtaining the solar cell of the present invention (i.e., a split cell). The first cutting line is located on the front side of the whole cell, the second cutting line is located on the back side of the whole cell, and the projection of the first cutting line on the back side overlaps with the second cutting line. In contrast, the conventional cell cutting process generally involves grooving first, laser scanning on cutting location by thermal cleavage laser, and then spraying coolant liquid mist along the same trajectory to complete the cutting. Compared with half-cells obtained using the conventional cell cutting process, the solar cell of the present invention can increase an open-circuit voltage by 0.5 mV, a fill factor by 0.3 to 0.4, a solar cell efficiency by 3% to 5%, and a module power by 0.5 W to 1 W.

In an embodiment, after obtaining the plurality of solar cells, the method for preparing the solar cell further includes forming a passivation film on the side surface and covering the textures.

In other embodiments, forming the passivation film on the side surface covering the textures includes: forming a first passivation sub-film covering the textures and forming a second passivation sub-film on the first passivation sub-film. A thickness of the second passivation sub-film in a second direction is greater than a thickness of the first passivation sub-film in the second direction, the second direction is perpendicular to the thickness direction of the cell substrate, and the second direction intersects with the first direction.

From the above description, it can be seen that the embodiments of the present invention achieve the following technical effects:
In the solar cell of the present invention, the solar cell is formed by cutting a whole cell. The solar cell includes a cell substrate and a plurality of textures arranged in the cell substrate, wherein the plurality of textures are spaced apart from each other along a first direction, and the density of plurality of the textures in the first direction is in a range from 1 texture per 10 µm to 30 textures per 10 µm. Compared with the issues in existing technology where high recombination and poor carrier transport in half-cells lead to lower module power, the texture density of 1 texture per 10 µm to 30 textures per 10 µm in the present invention can significantly reduce the number of dangling bonds. The reduction in the number of dangling bonds decreases the non-radiative recombination rate of carriers at the surface, thereby improving the conversion efficiency of the cell. Additionally, the relatively low texture density can make the side surface smoother, helping to reduce obstacles in the carrier transport path, thus improving carrier transport efficiency and consequently ensuring higher module power.

## Claims

1. A solar cell, comprising:
a cell substrate (10) comprising a front surface, a back surface, and a side surface (101) connecting the front surface and the back surface;
a plurality of textures (11) formed on the side surface (101), the plurality of textures (11) being spaced apart from each other in a first direction,
wherein in the first direction, a density of the plurality of the textures (11) is in a range from 1 texture (11) per 10 µm to 30 textures (11) per 10 µm, and the first direction is perpendicular to a thickness direction of the cell substrate (10).

2. The solar cell according to claim 1, wherein a depth of the texture (11) in a second direction is in a range from 0.1 µm to 3 µm, the second direction is perpendicular to the thickness direction of the cell substrate (10), and the second direction intersects the first direction.

3. The solar cell according to claim 1 or 2, wherein a width of the texture (11) in the first direction is in a range from 0 µm to 1 µm.

4. The solar cell according to any one of claims 1 to 3, further comprising: a passivation film (12) formed on the side surface (101).

5. The solar cell according to claim 4, wherein the passivation film (12) comprises:
a first passivation sub-film covering the plurality of textures (11);
a second passivation sub-film formed on the first passivation sub-film.

6. The solar cell according to claim 5, wherein a thickness of the second passivation sub-film is greater than a thickness of the first passivation sub-film.

7. The solar cell according to claim 5 or 6, wherein the thickness of the first passivation sub-film in the second direction is in a range from 10 nm to 20 nm, and the thickness of the second passivation sub-film in the second direction is in a range from 40 nm to 50 nm.

8. The solar cell according to any one of claims 4 to 7, wherein the passivation film (12) is made of at least one of aluminum oxide, silicon oxide, or silicon nitride.

9. The solar cell according to any one of claims 1 to 8, wherein a spacing between adjacent two textures (11) ranges from 0.3 µm to 9 µm.

10. The solar cell according to any one of claims 1 to 9, wherein sectional shapes of the plurality of textures (11) comprise at least one of linear, wavy, or zigzag.

11. The solar cell according to any one of claims 1 to 10, wherein the cell substrate (10) comprises a silicon substrate (13) and further comprises an emitter (14), a passivation layer (15), and a first antireflection film (16) that are stacked on one side of the silicon substrate (13), and also comprises a tunneling layer (17), a doped conductive layer (18), and a second antireflection film (19) that are stacked on another side of the silicon substrate (13).

12. The solar cell according to claim 11, wherein a doping type of the emitter (14) is different from a doping type of doped conductive layer (18).

13. The solar cell according to any one of claims 1 to 12, wherein a depth of the texture (11) located at both ends of the cell substrate (10) in the first direction is greater than a depth of the texture (11) located in a central part of the cell substrate (10).

14. The solar cell according to any one of claims 11 to 13, wherein the passivation layer (15) is made of one or more selected from the group consisting of silicon oxide, silicon nitride, silicon oxynitride, silicon oxycarbonitride, titanium oxide, hafnium oxide, and aluminum oxide.

15. A method for preparing the solar cell according to any one of claims 1 to 14, comprising:
providing a whole cell;
laser cutting the whole cell along a thickness direction of the whole cell to obtain a plurality of solar cells, wherein the solar cell comprises a cell substrate and a plurality of textures (11) arranged in the cell substrate, the plurality of textures (11) being spaced apart from each other in a first direction, wherein in the first direction, the density of plurality of the textures (11) is 1 texture (11) per 10 µm to 30 textures (11) per 10 µm, and the first direction is perpendicular to the thickness direction of the cell substrate.
